(19) Europäisches Patentamt
European Patent Office
Office européen des brevets

(11) Numéro de publication: **0 178 208**
**B1**

# (12) FASCICULE DE BREVET EUROPEEN

(45) Date de publication du fascicule du brevet: **12.04.89**

(51) Int. Cl.⁴: **C08F 30/08,** G03F 7/10

(21) Numéro de dépôt: **85401793.6**

(22) Date de dépôt: **17.09.85**

## (54) Film photosensible à base de polymère silicié et son utilisation comme résine de masquage dans un procédé de lithographie.

(30) Priorité: **21.09.84 FR 8414517**

(43) Date de publication de la demande:
**16.04.86 Bulletin 86/16**

(45) Mention de la délivrance du brevet:
**12.04.89 Bulletin 89/15**

(84) Etats contractants désignés:
**BE DE GB IT NL**

(56) Documents cités:
**EP-A- 0 096 596**
**EP-A- 0 108 624**

**CHEMICAL ABSTRACTS, vol. 103, 30 septembre 1985, page 571, no. 113359n, Columbus, Ohio, US; & JP - A - 60 52 845 (JAPAN SYNTHETIC RUBBER CO., LTD.) 26-03-1985**

(73) Titulaire: **COMMISSARIAT A L'ENERGIE ATOMIQUE, 31/33, rue de la Fédération, F-75015 Paris(FR)**

(72) Inventeur: **Bulguez, Francois, 22, rue Bonnais, F-38120 Saint Egreve(FR)**
Inventeur: **Giral, Louis, 1526 Avenue du Père Soulas Les Deux Ruisseaux No.2, F-34000 Montpellier(FR)**
Inventeur: **Rosilio, Charles, 16, Résidence Tournemire, F-91940 Les Ulis(FR)**
Inventeur: **Schue, Francois, 33, rue des Mimosas, F-67000 Strasbourg(FR)**

(74) Mandataire: **Mongrédien, André et al, c/o BREVATOME 25, rue de Ponthieu, F-75008 Paris(FR)**

**EP 0 178 208 B1**

Il est rappelé que: Dans un délai de neuf mois à compter de la date de publication de la mention de la délivrance du brevet européen toute personne peut faire opposition au brevet européen délivré, auprès de l'Office européen des brevets. L'opposition doit être formée par écrit et motivée. Elle n'est réputée formée qu'après paiement de la taxe d'opposition (Art. 99(1) Convention sur le brevet européen).

## Description

La présente invention a pour objet un film photosensible, utilisable notamment en microlithographie pour la réalisation de composants électroniques tels que des circuits intégrés.

La microlithographie est une technique largement employée, dans le domaine de la fabrication des composants électroniques, pour la réalisation sur un substrat de dessins ayant des traits de l'ordre du micron ou des traits submicroniques.

Dans ces techniques de microlithographie, on dépose généralement sur le substrat un film photosensible, puis on forme sur ce film par irradiation des dessins que l'on révèle ensuite en utilisant un solvant pour dissoudre soit les zones du film qui ont été exposées à l'irradiation, soit les zones du film qui n'ont pas été exposées à l'irradiation. De la sorte, on forme des ouvertures dans le film recouvrant le substrat et l'on peut ensuite effectuer des traitements tels qu'une gravure ou une implantation ionique sur les zones du substrat ainsi révélées.

Lors de l'irradiation, il se produit une réaction chimique dans le film qui peut conduire soit à une solubilité accrue du film due à une dépolymérisation ou à une modification chimique du film, soit au contraire, à une insolubilité du film dans certains solvants, qui résulte d'une réticulation ou d'une modification chimique. Aussi, en choisissant un solvant ou un traitement approprié, on peut éliminer le film soit aux endroits où il a été irradié, soit aux endroits où il n'a pas été irradié.

Dans le premier cas où l'on élimine les zones irradiées, le film photosensible est du type positif, alors que dans le second cas, où l'on élimine les zones non irradiées, le film photosensible est du type négatif. Dans tous les cas, le film photosensible doit remplir une double fonction. D'une part, il doit permettre un bon degré de résolution, c'est-à-dire une bonne définition des dessins constitués par exemple par des traits microniques ou submicroniques; d'autre part, les zones non éliminées du film doivent résister aux traitements suivants qui seront mis en œuvre pour la réalisation des circuits intégrés et, en particulier résister à la gravure à sec par plasma gazeux. Généralement, il est difficile de faire remplir parfaitement ces deux fonctions à une même couche de film photosensible; en effet, une bonne résolution du dessin nécessite une couche très fine, généralement d'épaisseur inférieure à 0,5 µm alors qu'une bonne résistance à la gravure à sec exige la présence d'une couche plus épaisse, généralement d'une épaisseur supérieure à 1 µm. Jusqu'à présent pour répondre à ces deux impératifs, on a utilisé des systèmes à plusieurs couches. De tels systèmes sont décrits en particulier dans l'article de B.J. LIN "Multilayer Resist Systems" paru dans l'ouvrage édité par L.F. THOMPSON, C.G. WILLSON et M.J. BOWDEN intitulé "Introduction to microlithography" ACS Symposium Series (Washington D.C.) 1983 pages 287 à 350.

Les figures 1 à 4 représentent un système multicouche de ce type et illustrent son utilisation pour masquer certaines zones d'un substrat.

Sur la figure 1, on voit que le substrat 1, constitué par exemple par un substrat en silicium, est recouvert d'un système multicouche 3 comportant trois couches 3a, 3b et 3c. La première couche 3a déposée directement sur le substrat 1 est une couche de résine épaisse, ayant par exemple une épaisseur de l'ordre de 2 µm, et elle est appelée couche de nivellement car elle a pour fonction de niveler les variations topographiques sur le substrat; la deuxième couche 3b est une couche intermédiaire qui est réalisée en matériau résistant aux plasmas gazeux réactifs, par exemple en $SiO_2$, Si, $Si_3N_4$ ou Al; la dernière couche 3c est une couche mince de résine photosensible d'une épaisseur de 0,2 à 0,5 µm, qui est utilisée pour l'inscription des motifs par irradiation avec une bonne résolution.

Pour inscrire des motifs sur un substrat utilisant un système de ce type, on irradie le substrat revêtu aux endroits voulus comme cela est représenté sur la figure 1, puis on élimine les zones de la couche 3c qui ont été irradiées par dissolution dans un solvant approprié; on obtient ainsi un substrat 1 recouvert des couches 3a et 3b et d'une couche 3c sur laquelle sont inscrits les motifs voulus comme représenté sur la figure 2.

A la suite de cette opération, on grave la couche 3b en transférant dans celle-ci les motifs inscrits dans la couche 3c par gravure, par exemple au moyen de trifluorométhane dans le cas où la couche 3b est en $SiO_2$, ce qui permet d'éliminer la couche 3b aux endroits où elle n'est pas protégée par la couche 3c de résine. On obtient ainsi la structure représentée sur la figure 3.

On transfère ensuite les motifs gravés de la couche 3b dans la couche de résine épaisse 3a par action d'un plasma gazeux réactif tel qu'un plasma d'oxygène, ce qui permet d'obtenir la structure représentée sur la figure 4 et d'éliminer simultanément la couche supérieure 3c de résine photosensible qui ne résiste pas à l'action du plasma gazeux réactif.

Cette technique donne des résultats satisfaisants en ce qui concerne la résolution des motifs, mais elle présente l'inconvénient d'être difficile à mettre en œuvre et d'être coûteuse. En effet, les couches de résine 3a et 3c peuvent être déposées par centrifugation, mais la couche intermédiaire 3b de $SiO_2$, de Si, de $Si_3N_4$ ou de Al est déposée par pulvérisation ou par dépôt chimique en phase vapeur, ce qui nécessite un appareillage compliqué et coûteux et des opérations plus complexes.

La présente invention a précisément pour objet un film photosensible qui pallie les inconvénients des systèmes multicouche précités tout en permettant d'obtenir une bonne résolution des motifs en microlithographie.

Le film photosensible selon l'invention, comprend:

a) au moins un polymère silicié répondant é la formule:

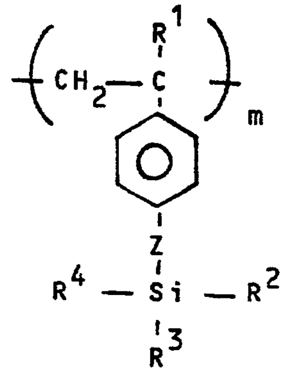

dans laquelle $R_1$ représente H ou un radical alkyle en $C_1$ à $C_4$, $R^2$, $R^3$ et $R^4$ qui peuvent être identiques ou différents, représentent un radical alkyle en $C_1$ à $C_4$, et Z représente –O–, $-(CH_2)_n-O-$ avec n étant un nombre entier de 1 à 4, ou

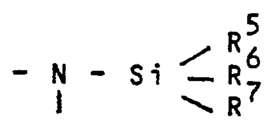

avec $R^5$, $R^6$ et $R^7$, qui peuvent être identiques ou différents, représentant un radical alkyle en $C_1$ à $C_4$, et m étant un nombre allant de 25 à 2000,

b) au moins un sel susceptible d'être transformé en un acide de Brönsted par irradiation et éventuellement

c) au moins un photosensibilisateur.

Avantageusement, il comprend pour 100 parties en poids dudit ou desdits polymères siliciés, 2 à 25 parties en poids, de préférence 5 à 15 parties en poids, du ou desdits sels et 0 à 10 parties en poids du ou desdits photosensibilisateurs.

L'utilisation, dans le film photosensible de l'invention, d'un polymère silicié répondant à la formule (I) et d'un sel capable d'être transformé par photolyse en un acide de Brönsted permet d'obtenir par irradiation à une longueur d'onde correspondant au domaine de photosensibilité du sel ou du photosensibilisateur, une transformation du polymère silicié de formule (I) en un polymère non silicié par coupure au niveau de la liaison O–Si ou N–Si. Dans le cas du polymère de formule (I) avec Z représentant –O–, cette réaction correspond au schéma réactionnel suivant:

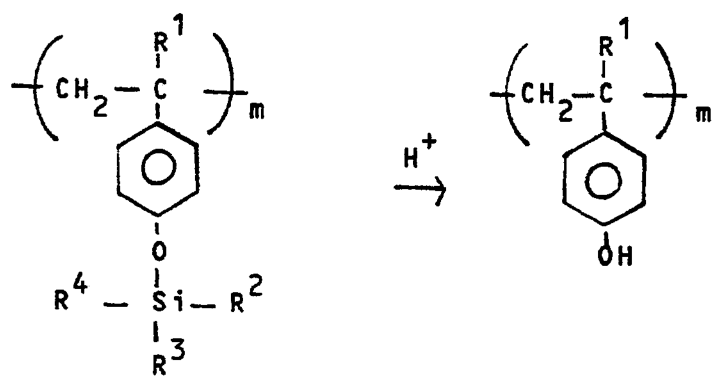


(II)

Dans le cas où Z représente $-(CH_2)_n-O-$, la réaction est du même type et conduit à un polystyrène-alcool. Dans le cas où Z représente

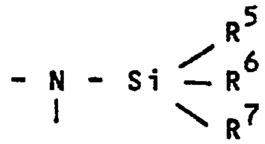

on obtient un polyaminostyrène.

Le polyvinylphénol de formule (II), le polystyrènealcool et le polyaminostyrène ainsi produits présentent des propriétés très différentes de celles du polymère silicié de formule (I), en particulier en ce qui concerne leur solubilité dans différents solvants et leur résistance aux plasmas gazeux réactifs. Ainsi, dans le cas où Z représente –O–, le polymère silicié de formule (I) est insoluble dans les solvants alcooliques et les solvants alcalins et il résiste aux plasmas gazeux réactifs, alors que le polyvinylphénol de formule (II) est soluble dans les solvants alcalins et alcooliques et présente une faible résistance aux plasmas gazeux réactifs. De ce fait, on peut tirer parti de cette différence de propriétés entre les deux polymères, en microlithographie, pour simplifier les systèmes à trois couches de l'art antérieur en remplaçant la couche intermédiaire et la couche mince photosensible de ces systèmes par le film photosensible de l'invention et éviter ainsi les opérations coûteuses et complexes se rapportant au dépôt de la couche intermédiaire.

Compte tenu des propriétés évoquées ci-dessus, ce film photosensible peut être utilisé comme film positif, les zones irradiées pouvant être éliminées sélectivement par dissolution en milieu alcalin ou alcoolique, en laissant intactes les zones non irradiées.

On peut toutefois envisager d'utiliser le film photosensible de l'invention comme film négatif, car le polyvinylphénol de formule (II) obtenu par irradiation est insoluble dans les solvants non polaires, ce qui permet de dissoudre le polymère de formule (I) non soumis à l'irradiation, au moyen d'un solvant non polaire approprié.

Les polymères siliciés répondant à la formule (I) peuvent être obtenus par polymérisation par voie radicalaire de monomères répondant à la formule (III):

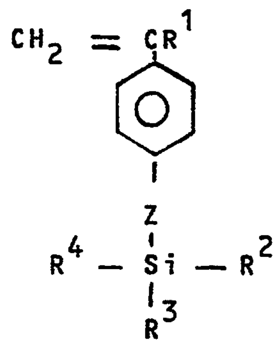

(III)

dans laquelle $R^1$, $R^2$, $R^3$, $R^4$ et Z ont la même signification que ci-dessus.

Cette polymérisation peut être amorcée au moyen d'un agent d'amorçage, tel que l'azo-bis-isobutyronitrile. Dans le cas où Z représente –O– ou $-(CH_2)_n-O-$, le monomère de départ peut être obtenu par réaction d'un composé de formule:

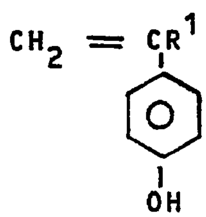

ou

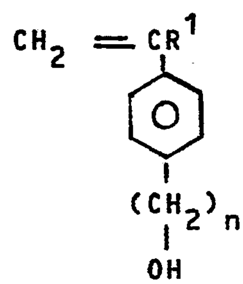

avec un excès d'un composé de formule:

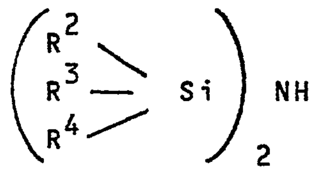

Dans le cas où Z représente

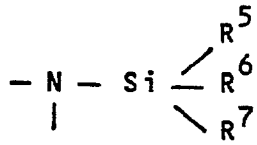

Le monomère de départ peut être obtenu par réaction de:

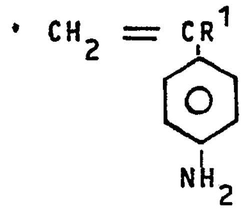

avec un excès du composé de formule

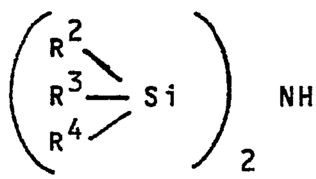

A titre d'exemples de monomères de départ susceptibles d'être utilisés, on peut citer:

– le p-triméthylsilyloxystyrène

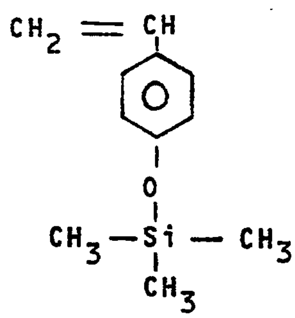

– le p-triméthylsilyloxy(α-méthylstyrène)

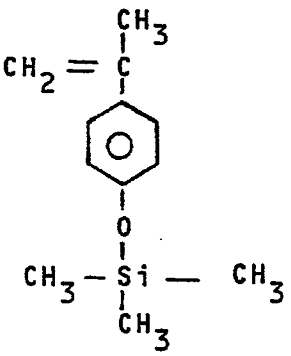

– le p-triméthylsilyléthoxystyrène

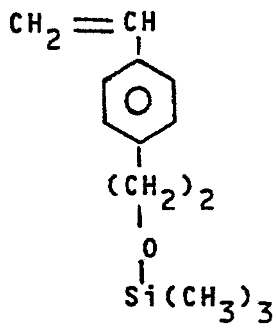

– le para-N,N-bis(triméthyl silyl) aminostyrène

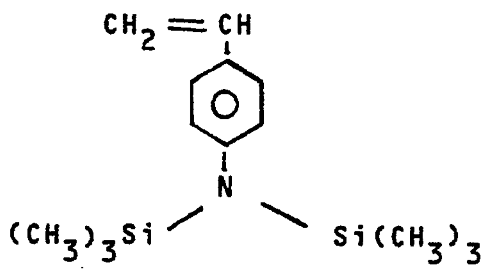

Dans le film photosensible de l'invention, on utilise avantageusement les polymères siliciés de formule (I) dans laquelle $R^1$ représente l'hydrogène ou un radical méthyle, soit les polymères dérivés du styrène ou de l'α-méthylstyrène.

Dans les polymères siliciés de l'invention, les radicaux alkyle $R^2$, $R^3$ et $R^4$ ainsi que les radicaux alkyle $R^5$, $R^6$ et $R^7$ sont généralement des radicaux alkyle identiques, et de préférence des radicaux méthyle.

Afin de pouvoir obtenir la transformation du polymère silicié en polymère non silicié par réaction avec un acide, le film photosensible de l'invention comprend obligatoirement un sel susceptible d'être transformé en un acide de Brönsted par irradiation ce qui permet de former "in situ" dans le film, par irradiation, l'acide nécessaire à la transformation du polymère silicié. Ces sels sont des sels connus sous le nom de sels de Crivello, et ils sont décrits en particulier dans la publication suivante: J.V. Crivello, Advance in Polymer Science, Vol. 62, (1984), pages 1–48.

A titre d'exemples de tels sels, on peut citer les sels de triarylsulfonium, les sels de dialkylphénacyl sulfonium, les sels de dialkylhydroxy phényl sulfonium, les sels de diaryl iodonium, les sels de triarylsélénonium et les sels de triaryltelluronium.

Les sels de sulfonium peuvent répondre à la formule:

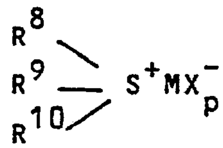

dans laquelle $R^8$, $R^9$ et $R^{10}$ qui peuvent être identiques ou différents, représentent des radicaux aryle ou alkyle éventuellement substitués, M est un élément de la classification périodique des éléments susceptible de former un anion avec un halogène, X est un atome d'halogène et p est égal à v+1 avec v représentant l'état de valence de M.

Dans cette formule, $R^8$, $R^9$ et $R^{10}$ peuvent représenter un radical alkyle, un radical phényle, un radical phényle substitué par au moins un substituant choisi parmi les radicaux alkyle, alkoxy, alkylamido, les atomes d'halogène, le radical hydroxyle et le radical nitro.

Deux des radicaux $R^8$, $R^9$ et $R^{10}$ pouvant aussi former ensemble avec l'atome de soufre auquel ils sont liés un hétérocycle tel que:

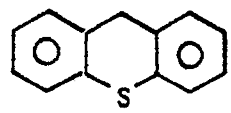

A titre d'exemple de cation

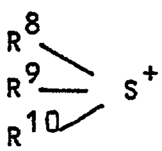 , on peut citer les cations suivants :

$(C_6H_5)_3\ S^+$

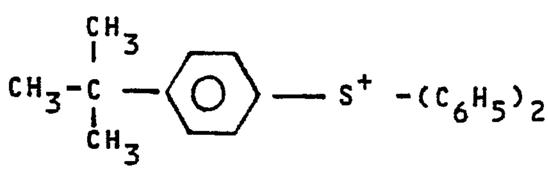

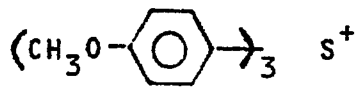

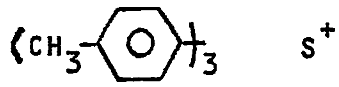

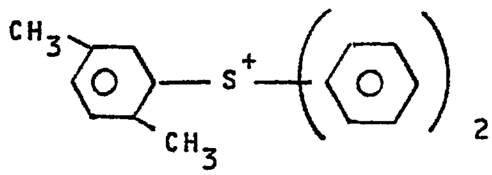

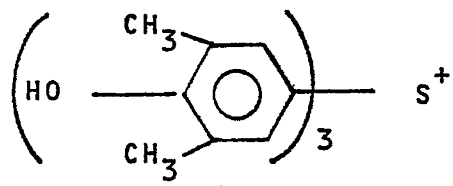

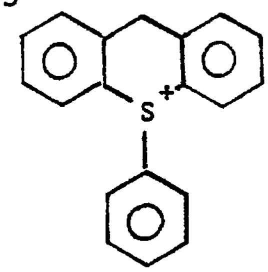

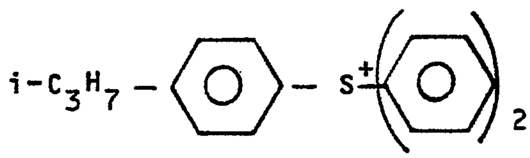

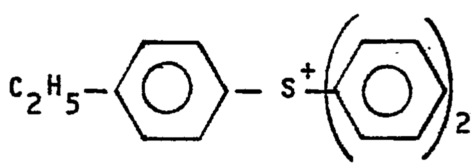

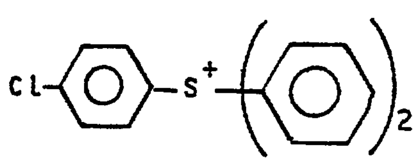

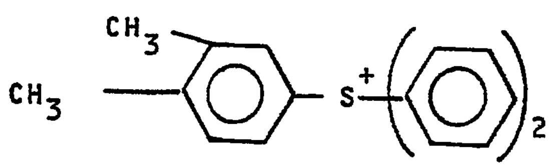

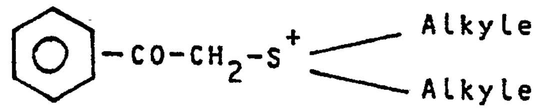

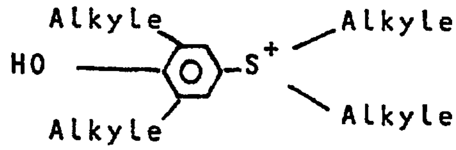

A titre d'exemple, l'anion $MX_p^-$ peut être choisi parmi $BF_4^-$, $AsF_6^-$, $PF_6^-$ et $SbF_6^-$.

Les sels de diaryliodonium peuvent répondre à la formule

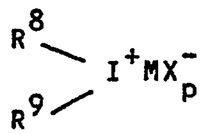

dans laquelle $R^8$ et $R^9$, qui peuvent être identiques ou différents, représentent un radical aryle éventuellement substitué, M représente un élément de la classification périodique des éléments susceptible de former un anion avec un halogène, X représente un atome d'halogène et p est égal à 1+v avec v représentant l'état de valence de M.

Les radicaux aryle susceptibles d'être utilisés sont du même type que ceux précédemment cités pour les sels de triarylsulfonium. A titre d'exemples, le cation $Ar_2I^+$ peut répondre aux formules suivantes:

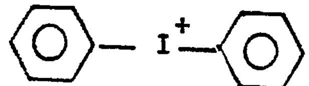

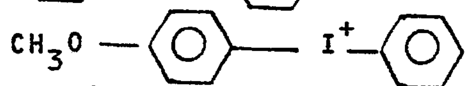

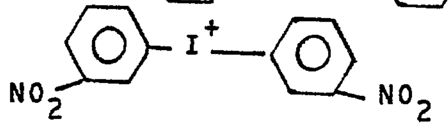

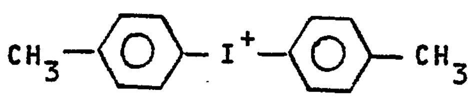

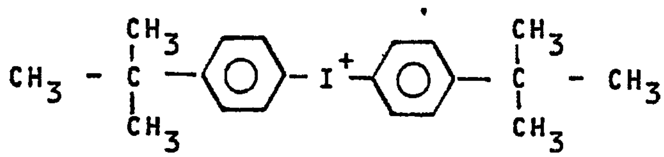

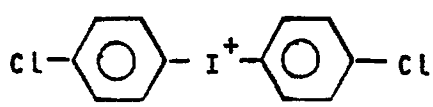

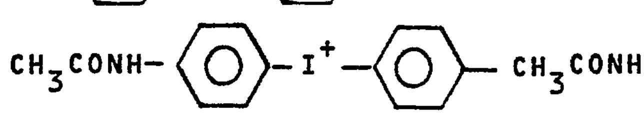

Dans les sels de diaryliodonium, l'anion $MX_p^-$ peut être l'un des anions cités précédemment.

Les sels de Crivello présentent la propriété d'être photosensibles dans certaines gammes de longueurs d'onde qui dépendent de la nature du sel et de pouvoir ainsi être transformés par irradiation dans cette gamme de longueur d'onde en un acide de Brunsted.

Dans le cas des sels de triarylsulfonium, le domaine de photosensibilité des sels se situe dans la gamme de longueurs d'onde de 220 à 320 nm. Dans le cas des sels de diaryliodonium, le domaine de photosensibilité des sels se situe dans la gamme de longueurs d'onde allant de 210 à 280 nm.

Toutefois, on peut, selon l'invention, modifier le domaine de photosensibilité des sels de Crivello précités en ajoutant à la composition un photosensibilisateur qui peut être présent, à raison de 3 à 10 parties en poids pour 100 parties en poids du polymère silicié.

Le photosensibilisateur peut être un hydrocarbure aromatique tel que le pérylène, le pyrène, l'anthracène et le tétracène, la phénothiazine et l'acétophénone et il est choisi en fonction du sel de Crivello utilisé. Ainsi, dans le cas des sels de triarylsulfonium, on peut utiliser le pérylène qui modifie le domaine de photosensibilité de ces sels en l'amenant dans la gamme de longueurs d'onde allant de 386 à 475 nm, la photosensibilité maximale étant observée à 436 nm, et une photosensibilité suffisante étant observée à 405 nm.

Aussi, dans la présente invention, on entend par domaine de photosensibilité du film, la gamme de longueurs d'onde dans laquelle le sel est photosensible lorsque le film ne comprend pas de photosensibilisateur, ou la gamme de longueurs d'onde dans laquelle le photosensibilisateur est sensible lorsque le film comprend un tel agent photosensibilisateur.

Grâce à leur photosensibilité et à leur résistance à certains réactifs, en particulier aux plasmas gazeux réactifs, les films photosensibles de l'invention peuvent être utilisés comme films positifs en microlithographie en étant associés à une couche de résine épaisse ayant pour but de niveler les variations topographiques du substrat. On peut ainsi remplacer les systèmes à trois couches de l'art antérieur par un système à deux couches, selon l'invention, ce qui permet en particulier d'éviter l'étape de dépôt de la couche intermédiaire par réaction chimique en phase vapeur et d'éviter également l'étape de gravure par plasma de la couche intermédiaire.

L'invention a donc également pour objet un procédé pour masquer certaines zones d'un substrat, qui comprend les étapes successives suivantes:

a) déposer sur ledit substrat une première couche de résine ayant une épaisseur telle qu'elle constitue une couche de nivellement du substrat,

b) déposer sur ladite première couche de résine une seconde couche du film photosensible de l'invention,

c) irradier les zones de la seconde couche correspondant aux zones du substrat qui ne doivent pas être masquées, au moyen de rayonnements ayant une longueur d'onde correspondant au domaine de photosensibilité du film photosensible, et

d) éliminer la seconde couche de film photosensible et la première couche de résine aux endroits correspondant aux zones de la seconde couche qui ont été irradiées.

Selon un premier mode de réalisation du procédé de l'invention, dans l'étape d), on élimine tout d'abord la seconde couche de film photosensible par dissolution dans un solvant et on élimine ensuite la première couche de résine par gravure ionique réactive dans un plasma gazeux.

Comme on l'a vu précédemment, l'irradiation de la seconde couche de film photosensible transforme le polymère silicié de formule (I) en un polymère non silicié, par exemple en un polyphénol de formule (II), qui présente la propriété d'être soluble dans des solvants alcalins et des solvants alcooliques, alors que le polymère silicié de formule (I) est insoluble dans ces mêmes solvants. Aussi, on peut éliminer la seconde couche de film photosensible aux endroits qui ont été exposés aux rayonnements par dissolution dans un solvant alcalin tel que la soude, la potasse, et les sels d'ammonium quaternaires ou dans un solvant alcoolique tel que le méthanol.

Ensuite, on peut éliminer la première couche, par exemple par gravure ionique réactive dans un plasma gazeux, car le polymère silicié de formule (I) présente une résistance élevée à l'action des plasmas gazeux réactifs tels qu'un plasma d'oxygène.

Selon un second mode de réalisation du procédé de l'invention, dans l'étape d), on élimine simultanément la seconde couche de film photosensible et la première couche de résine par gravure ionique réactive dans un plasma gazeux tel qu'un plasma d'oxygène. En effet, le polymère non silicié obtenu lors de l'irradiation présente une faible résistance à l'action des plasmas gazeux réactifs tels qu'un plasma d'oxygène et on peut donc éliminer simultanément la première et la seconde couches déposées sur le substrat aux endroits qui correspondent aux zones de la seconde couche qui ont été irradiées. Dans ce second mode de réalisation du procédé de l'invention, il est avantageux d'utiliser dans l'étape c) une dose d'irradiation sensiblement plus importante que dans le cas du premier mode de réalisation du procédé, afin d'obtenir un développement complet.

Pour la mise en œuvre du procédé de l'invention, la première couche de résine peut être déposée par des procédés classiques, par exemple par centrifugation. L'épaisseur déposée est généralement d'environ 2 µm comme dans les procédés de l'art antérieur. On peut utiliser pour former cette première couche des résines du même type que celles de l'art antérieur, par exemple des résines phénol-formaldéhyde comme les résines Novolaques qui ne résistent pas à l'action d'un plasma gazeux réactif. Généralement, après dépôt de cette première couche de résine sur le substrat, on soumet celle-ci à un recuit pour durcir la résine et la rendre inactive. Ce durcissement s'accompagne généralement d'une modification du spectre d'absorption ultraviolet de la résine et la rend plus absorbante au voisinage de 400 nm, ce qui permet d'éviter qu'il ne se produise lors de l'irradiation du substrat revêtu des deux couches, des réflexions de la lumière incidente sur le substrat, qui seraient nuisibles pour l'obtention d'une bonne résolution du dessin.

La deuxième couche de film photosensible peut être déposée également par centrifugation. Généralement, on dissout la composition comprenant au moins un polymère silicié, au moins un sel de Crivello et

éventuellement au moins un photosensibilisateur, dans un solvant approprié tel que le dichlorométhane. L'épaisseur de film déposé ne dépasse généralement pas 0,4 µm et elle est avantageusement de 0,2 à 0,4 µm pour obtenir une bonne résolution. Après dépôt de la seconde couche, on soumet celle-ci à un séchage pour éliminer le solvant.

Selon un mode préféré de mise en œuvre du procédé de l'invention, le film photosensible comprend pour 100 parties en poids de poly-p-triméthyl-silyloxystyrène, 5 à 15 parties en poids d'hexafluoroarséniate de triphénylsulfonium et 3 à 10 parties en poids de pérylène. Dans ces conditions, on peut réaliser l'irradiation à une longueur d'onde de 386 à 475 nm, et de préférence à 436 nm.

L'invention a encore pour objet des polymères siliciés utilisables pour former un film photosensible, qui répondent à la formule:

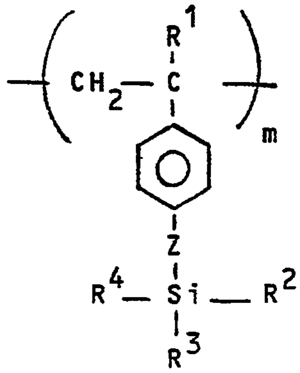

(I)

dans laquelle $R^1$ représente H ou un radical alkyle en $C_1$ à $C_4$, $R^2$, $R^3$ et $R^4$ qui peuvent être identiques ou différents, représentent un radical alkyle en $C_1$ à $C_4$ Z représente $-O-$, $-(CH_2)_n-O-$ avec n étant un nombre entier de 1 à 4, ou

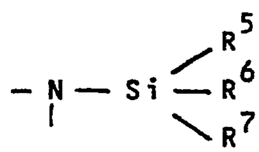

avec $R^5$, $R^6$ et $R^7$ qui peuvent être identiques ou différents, représentant un radical alkyle en $C_1$ à $C_4$, et m est un nombre allant de 25 à 2000 à condition que $R^2$, $R^3$ et $R^4$ ne représentent pas $CH_3$ lorsque $R_1$ représente H et que Z représente $-O-$, $-O-CH_2-CH_2-$ ou $-N-Si(CH_3)_3$.

D'autres caractéristiques et avantages de l'invention apparaîtront mieux à la lecture de l'exemple qui suit donné bien entendu à titre illustratif et non limitatif en référence au dessin annexé sur lequel:

- les figures 1 à 4 qui ont déjà été décrites, représentent un film multicouche selon l'art antérieur,
- les figures 5, 6 et 7 illustrent l'utilisation du film photosensible de l'invention en microlithographie, et
- la figure 8 illustre le spectre d'absorption infrarouge d'un substrat revêtu du film photosensible de l'invention avant et après irradiation à 436 nm.

Dans cet exemple, on utilise comme film photosensible selon l'invention, un film comprenant un polymère silicié de formule:

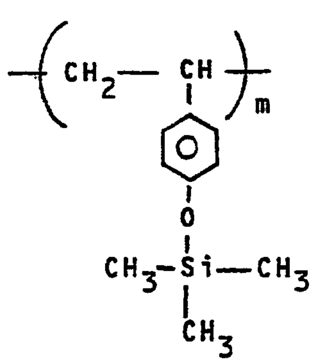

Ce polymère a été obtenu par polymérisation radicalaire de p-triméthylsilyloxystyrène en solution dans du toluène en utilisant comme amorceur de polymérisation de l'azo-bis-isobutyronitrile et en effectuant la

polymérisation à une température de 69°C pendant 24 heures, ce qui conduit à un rendement de 73%. Le polymère obtenu a été caractérisé par chromatographie en phase gazeuse et l'on a obtenu les résultats suivants:

– masse moléculaire moyenne (en nombre) $\bar{M}_n$=51000

– masse moléculaire moyenne (en poids) $\bar{M}_p$ (ou$\bar{M}_v$) = 117600

$$- \text{indice de dispersion } \frac{\bar{M}_p}{\bar{M}_n} : 2{,}31, \text{ et}$$

– température de transition vitreuse $T_v$: 75–76°C déterminée par analyse thermique différentielle.

Le polymère obtenu est soluble dans le tétrahydrofurane, le benzène, le chlorure de méthylène, le chloroforme, l'éther de pétrole, l'éther éthylique, l'acétone, le toluène et le tétrachlorure de carbone. En revanche, il est insoluble dans le méthanol, l'eau et les solutions alcalines.

Le monomère de départ a été obtenu à partir de vinyl-4 phénol par traitement avec un excès d'hexaméthyldisilazane de formule $[(CH_3)_3Si]_2$ NH à une température de 30°C, pendant 10 heures. Le monomère pur a été isolé par distillation fractionnée. La réaction correspond à un rendement de 90% et le point d'ébullition du monomère est de 65°C sous 4 millibars (400 Pa).

Dans le film photosensible de cet exemple, on utilise comme sel de Crivello, l'hexafluoroarséniate de triphénylsulfonium (point de fusion: 195 à 198°C).

Pour rendre la composition de polymère silicié et de sel de Crivello photosensible à une longueur d'onde de 436 nm, on lui ajoute du pérylène qui joue le rôle d'agent photosensibilisateur.

On peut alors utiliser cette composition pour masquer certaines zones d'un substrat constitué dans cet exemple par une plaquette de silicium.

Sur cette plaquette de silicium, on dépose tout d'abord par centrifugation une première couche de résine Novolaque commercialisée sous la marque HPR 206 par HUNT CHEMICAL Cy, en utilisant une vitesse de 4000 t/min pour obtenir une première couche de résine ayant une épaisseur d'environ 2 µm, qui sert de couche de nivellement du substrat en silicium.

On soumet ensuite la couche de résine ainsi déposée à un recuit effectué à 220°C, soit dans une étuve pendant une heure, soit sur une plaque chauffante pendant 2 min. Ce recuit provoque un durcissement de la résine et la rend inactive. Par ailleurs, le durcissement conduit à une modification du spectre d'absorption ultraviolet de la résine et l'absorption devient importante à la longueur d'onde de 436 nm, ce qui permet d'éviter ensuite des réflexions de la lumière incidente sur le substrat, qui seraient nuisibles pour obtenir une haute résolution. En revanche, l'absorption à 550 nm est faible, ce qui permet d'utiliser cette longueur d'onde pour réaliser le positionnement de la plaquette de silicium sur le dispositif d'irradiation. Après ces opérations, on dépose, sur la plaquette de silicium ainsi revêtue, une couche du film photosensible à partir d'une solution du film dans du dichlorométhane qui a été obtenue en dissolvant dans 100 ml de dichlorométhane 10 g de poly-p-triméthylsilyloxystyrène, 1 g d'hexafluoroarséniate de triphénylsulfonium et 0,5 g de pérylène et en filtrant ensuite la solution sur un filtre Millipore ayant une ouverture de pores de 0,5 µm.

On réalise le dépôt par centrifugation de façon à recouvrir la plaquette de silicium revêtue de résine Novolaque d'une seconde couche ayant une épaisseur de 0,4 µm. On sèche ensuite la seconde couche de film photosensible pour éliminer le solvant à une température de 65°C, soit pendant 15 min dans une étuve, soit pendant 2 min sur une plaque chauffante.

On obtient ainsi la plaquette revêtue illustrée sur la figure 5. Sur cette figure, on voit que le substrat 21 constitué par la plaquette de silicium est recouvert d'une première couche 23 de résine ayant une épaisseur relativement importante (2 µm) et d'une seconde couche 25 du film photosensible de l'invention.

Pour former un masque sur certaines zones du substrat 21, on soumet alors l'ensemble à une irradiation par des rayonnements ayant une longueur d'onde de 436 nm en utilisant un dispositif de masquage 27 interposé entre la source de rayonnements et la plaquette de silicium revêtue afin d'irradier seulement les zones 25a de la couche 25 de film photosensible.

Pour réaliser cette irradiation, on utilise un photorépéteur et une dose totale d'irradiation de 80 $mJ/cm^2$. Après irradiation, le polymère silicié des zones 25a de la couche de film photosensible 25 a été converti par réaction avec l'acide de Brönsted produit par photolyse de l'hexafluoroarséniate de triphénylsulfonium, en présence de pérylène, en un polyvinylphénol de formule (II). Cette modification des zones 25a a pu être mise en évidence par spectrométrie infrarouge du substrat revêtu de la couche de film photosensible avant et après irradiation.

La figure 8 illustre les résultats obtenus en spectrométrie infrarouge. Ainsi, sur cette figure, les courbes (A) se rapportent au spectre d'absorption infrarouge obtenu avant irradiation du substrat revêtu et les courbes (B) se rapportent au spectre d'absorption infrarouge obtenu après irradiation. Au vu de cette figure, on constate que le polymère silicié s'est transformé en polyvinylphénol.

Après irradiation, on soumet la plaquette revêtue à un traitement de recuit effectué pendant 5 min à

65°C pour amplifier la réaction chimique de transformation du polymère de formule (I) en polymère de formule (II) dans les zones 25a qui ont été soumises à l'irradiation. A ce stade, les motifs apparaissent déjà sur la plaquette, les zones 25a de la seconde couche 25 étant légèrement en creux par rapport au reste de la couche.

On procède alors à l'élimination de la seconde couche sur les zones 25a par dissolution au moyen d'une solution alcoolique. Dans ce but, on introduit la plaquette dans un bain de méthanol, à 20°C, pendant une minute, puis on la sèche sous un jet d'azote sec. On obtient ainsi la structure représentée sur la figure 6, c'est-à-dire l'élimination des zones 25a de la seconde couche 25 et la formation de motifs en creux dans cette couche.

On transfère ensuite les motifs ainsi formés dans la première couche épaisse 23 de résine HPR 206. Ceci est réalisé par gravure ionique réactive dans un plasma d'oxygène. Dans ce but, on dispose la plaquette de silicium sur la cathode d'un réacteur de gravure ionique réactive et on réalise la gravure par le plasma d'oxygène dans les conditions suivantes:

– pression d'oxygène: 10 millitorr, (1,35 Pa),
– débit d'oxygène: 10 $cm^3$/min,
– fréquence du générateur: 13,56 MHz,
– puissance: 0,5 $W/cm^2$.

On détecte la fin de l'attaque de la couche 23 par interférométrie laser.

On obtient ainsi une élimination de la couche 23 sur les zones qui ne sont pas protégées par la couche 25. En effet, dans ces conditions de gravure par le plasma d'oxygène, la vitesse de gravure de la résine 23 est de l'ordre de 120 nm/min alors que, pour le film photosensible 25, l'érosion est pratiquement nulle, la vitesse de gravure étant de 5 nm/min.

Ainsi, la seconde couche 25 sert de masque in situ lors de la gravure anisotrope de la première couche 23 et l'on obtient, en fin d'opération, la structure représentée sur la figure 7, c'est-à-dire le transfert des motifs de la couche 25 dans la couche 23.

Par observation au microscope électronique de la structure obtenue sur la figure 7, on constate que les motifs gravés ont une largeur de trait de 0,65 à 0,7 µm sur des épaisseurs d'environ 2 µm. Ainsi, les motifs submicroniques obtenus avec une grande résolution sur la seconde couche 25 de film photosensible de l'invention, ont été transférés dans la première couche de résine 23 avec conservation de la largeur de trait au cours de la gravure par le plasma d'oxygène.

Dans une variante de réalisation de cet exemple, on évite l'étape intermédiaire représentée sur la figure 6 en éliminant directement par voie sèche les zones 25a de la seconde couche 25 et les zones correspondantes de la première couche 23.

Dans ce cas, on réalise le revêtement de la plaquette de silicium 21 par la première couche 23 de résine HPR 206 et par la seconde couche 25 de film photosensible dans les mêmes conditions que précédemment. Ensuite, on soumet la plaquette revêtue à une irradiation à 436 nm en utilisant le même dispositif de masquage 27 et le même appareillage d'irradiation, mais en poursuivant l'irradiation jusqu'à l'obtention d'une dose de 100 à 120 $mJ/cm^2$. On obtient ainsi, comme précédemment, une modification de la seconde couche 25 sur les zones 25a et, après irradiation, on soumet également l'ensemble à un recuit effectué pendant 5 min à 65°C.

Après cette opération, on soumet directement la plaquette irradiée à l'action du plasma gazeux d'oxygène en la disposant sur la cathode du réacteur de gravure ionique réactive et en réalisant la gravure dans les mêmes conditions que précédemment.

On obtient ainsi l'élimination des zones 25a de la seconde couche 25 et l'élimination des zones correspondantes de la couche 23, ce qui permet d'obtenir directement la structure représentée sur la figure 7. Dans ces conditions, les vitesses de gravure de la seconde couche 25 sur les zones 25a et de la première couche 23 sont respectivement de 75 nm/min et de 70 nm/min, alors que la vitesse de gravure de la couche 25 sur les endroits où elle n'a pas été irradiée, n'est que de 3 nm/min. On obtient ainsi une sélectivité élevée, ce qui permet de réaliser simultanément l'élimination des couches 23 et 25 aux endroits voulus par gravure ionique réactive dans le plasma gazeux d'oxygène.

Cette variante de réalisation est particulièrement intéressante car elle permet de réaliser simultanément le développement de la seconde couche et la gravure de la première couche par voie sèche au moyen d'un plasma, ce qui est plus facile à mettre en œuvre, plus rapide et permet d'éviter les inconvénients des développements par voie humide.

## Revendications

1. Film photosensible, caractérisé en ce qu'il comprend:

a) au moins un polymère silicié répondant à la formule:

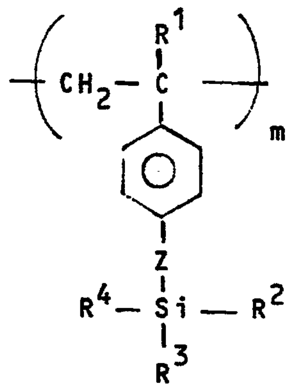

(I)

dans laquelle $R^1$ représente H ou un radical alkyle en $C_1$ à $C_4$, $R^2$ et $R^4$, qui peuvent être identiques ou différents, représentent un radical alkyle en $C_1$ à $C_4$ Z représente –O–, $-(CH_2)_n-O-$ avec n étant un nombre entier de 1 à 4, ou

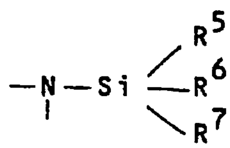

avec $R^5$, $R^6$ et $R^7$, qui peuvent être identiques ou différents, représentant un radical alkyle en $C_1$ à $C_4$, et m est un nombre allant de 25 à 2000; et

b) au moins un sel susceptible d'être transformé en un acide de Brönsted par irradiation.

2. Film photosensible selon la revendication 1, caractérisé en ce qu'il comprend de plus:

c) au moins un photosensibilisateur.

3. Film photosensible selon l'une quelconque des revendications 1 et 2, caractérisé en ce qu'il comprend

pour 100 parties en poids du ou desdits polymères siliciés, 2 à 25 parties en poids du ou desdits sels et 0 à 10 parties en poids du ou desdits photosensibilisateurs.

4. Film photosensible selon l'une quelconque des revendications 2 et 3, caractérisé en ce qu'il comprend 3 à 10 parties en poids du ou desdits photosensibilisateurs pour 100 parties en poids du ou desdits polymères.

5. Film photosensible selon l'une quelconque des revendications 1 à 4, caractérisé en ce que dans la formule (I) du polymère silicié, $R^1$ représente H ou $CH_3$.

6. Film photosensible selon la revendication 5, caractérisé en ce que dans la formule (I) du polymère silicié, $R^2$, $R^3$, $R^4$, $R^5$, $R^6$ et $R^7$ représentent le radical méthyle.

7. Film photosensible selon l'une quelconque des revendications 1 à 4, caractérisé en ce que le polymère silicié répond à la formule:

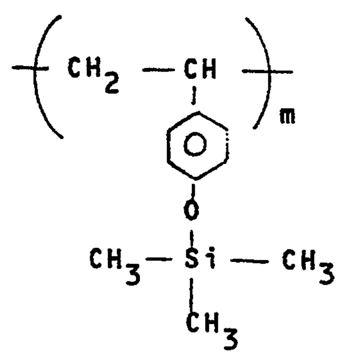

8. Film photosensible selon l'une quelconque des revendications 1 à 7, caractérisé en ce que ledit sel est choisi parmi les sels de sulfonium, les sels de diaryliodonium, les sels de triarylsélénonium et les sels de triaryltelluronium.

9. Film photosensible selon la revendication 8, caractérisé en ce que le sel de sulfonium est un sel de formule:

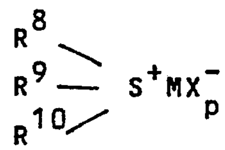

dans laquelle $R^8$, $R^9$ et $R^{10}$, qui peuvent être identiques ou différents, sont des radicaux aryle ou alkyle éventuellement substitués, M est un élément de la classification périodique des éléments susceptible de former un anion avec un halogène, X est un atome d'halogène et p est égal à v+1 avec v représentant l'état de valence de M.

10. Film photosensible selon la revendication 8, caractérisé en ce que le sel de diaryliodonium répond à la formule:

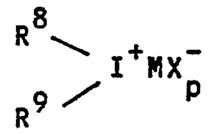

dans laquelle $R^8$ et $R^9$, qui peuvent être identiques ou différents, représentent un radical aryle éventuellement substitué, M représente un élément de la classification périodique des éléments susceptible de former un anion avec un halogène, X représente un atome d'halogène et p est égal à 1+v avec v représentant la valence de M.

11. Film photosensible selon l'une quelconque des revendications 9 et 10, caractérisé en ce que $MX_p^-$ est choisi parmi $BF_4^-$, $AsF_6^-$, $PF_6^-$ et $SbF_6^-$.

12. Film photosensible selon l'une quelconque des revendications 1 à 7, caractérisé en ce que ledit sel est l'hexafluoroarséniate de triphénylsulfonium ou l'hexafluoroarséniate de diphényliodonium.

13. Film photosensible selon l'une quelconque des revendications 1 à 12, caractérisé en ce que le photosensibilisateur est un hydrocarbure aromatique.

14. Film photosensible selon la revendication 12, caractérisé en ce que le photosensibilisateur est du pérylène.

15. Procédé pour masquer certaines zones d'un substrat, caractérisé en ce qu'il comprend les étapes successives suivantes:

a) déposer sur ledit substrat une première couche de résine ayant une épaisseur telle qu'elle constitue une couche de nivellement du substrat,

b) déposer sur ladite première couche de résine une seconde couche du film photosensible selon l'une quelconque des revendications 1 à 14,

c) irradier les zones de la seconde couche correspondant aux zones du substrat qui ne doivent pas être masquées, au moyen de rayonnements ayant une longueur d'onde qui correspond au domaine de photosensibilité du film photosensible, et

d) éliminer la seconde couche de film photosensible et la première couche de résine aux endroits correspondant aux zones de la seconde couche qui ont été irradiées.

16. Procédé selon la revendication 15, caractérisé en ce que dans l'étape d), on élimine tout d'abord la seconde couche de film photosensible par dissolution dans un solvant et en ce que l'on élimine ensuite la première couche de résine par gravure ionique réactive dans un plasma gazeux.

17. Procédé selon la revendication 15, caractérisé en ce que dans l'étape d), on élimine simultanément la seconde couche de film photosensible et la première couche de résine par gravure ionique réactive dans un plasma gazeux.

18. Procédé selon l'une quelconque des revendications 15 à 17, caractérisé en ce que, après irradiation, on soumet la seconde couche de film photosensible à un recuit.

19. Procédé selon l'une quelconque des revendications 15 à 18, caractérisé en ce que la première couche de résine est constituée de résine phénol formaldéhyde.

20. Procédé selon l'une quelconque des revendications 15 à 19, caractérisé en ce que le film photosensible comprend pour 100 parties en poids de poly-p-triméthylsilyloxystyrène, 5 à 15 parties en poids d'hexafluoroarséniate de triphénylsulfonium et 3 à 10 parties en poids de pérylène.

21. Procédé selon la revendication 20, caractérisé en ce que l'on réalise l'irradiation à une longueur d'onde de 386 à 475 nm.

22. Polymère silicié, caractérisé en ce qu'il répond à la formule:

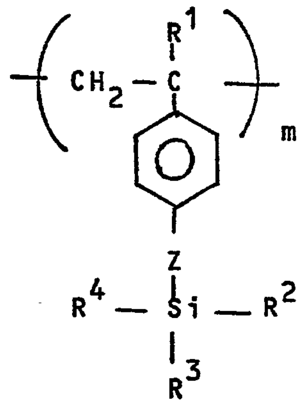

(I)

dans laquelle R1 représente H ou un radical alkyle en $C_1$ à $C_4$, $R^2$, $R^3$ et $R^4$, qui peuvent être identiques ou différents, représentent un radical alkyle en $C_1$ à $C_4$, Z représente –O–, $-(CH_2)_n-O-$ avec n étant un nombre entier de 1 à 4, ou

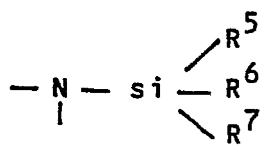

avec $R^5$, $R^6$ et $R^7$, qui peuvent être identiques ou différents, représentant un radical alkyle en $C_1$ à $C_4$, et m est un nombre allant de 25 à 2000 à condition que $R^2$, $R^3$ et $R^4$ ne représentent pas $CH_3$ lorsque $R^1$ représente H et que Z représente –O–, $-O-CH_2-CH_2-$ ou $-N-Si(CH_3)_3$.

**Patentansprüche**

1. Lichtempfindlicher Film, dadurch gekennzeichnet, daß er umfaßt:
a) mindestens ein siliciumhaltiges Polymeres der Formel

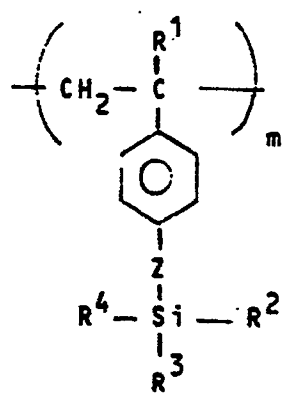

(I)

worin bedeuten:
$R^1$ H oder einen $C_1$–$C_4$–Alkylrest,
$R^2$, $R^3$ und $R^4$, die gleich oder verschieden sein können, einen $C_1$–$C_4$-Alkylrest,
Z–O–, $-(CH_2)_n-O-$, worin n eine ganze Zahl von 1 bis 4 darstellt, oder

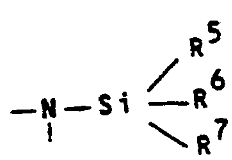

worin $R^5$, $R^6$ und $R^7$, die gleich oder verschieden sein können, einen $C_1$–$C_4$-Alkylrest darstellen, und m eine ganze Zahl von 25 bis 2000, und

b) mindestens ein Salz, das durch Bestrahlung in eine Brönsted-Säure überführt werden kann.

2. Lichtempfindlicher Film nach Anspruch 1, dadurch gekennzeichnet, daß er außerdem umfaßt:

c) mindestens einen Photosensibilisator.

3. Lichtempfindlicher Film nach einem der Ansprüche 1 und 2, dadurch gekennzeichnet, daß er auf 100 Gew.-Teile des oder der genannten siliciumhaltigen Polymeren 2 bis 25 Gew.-Teile des oder der Salze und 0 bis 10 Gew.-Teile des oder der Photosensibilisatoren enthält.

4. Lichtempfindlicher Film nach einem der Ansprüche 2 und 3, dadurch gekennzeichnet, daß er 3 bis 10 Gew.-Teile des oder der Photosensibilisatoren auf 100 Gew.-Teile des oder der Polymeren enthält.

5. Lichtempfindlicher Film nach einem der Ansprüche 1 bis 4, dadurch gekennzeichnet, daß in der Formel (I) des siliciumhaltigen Polymeren $R^1$ H oder $CH_3$ darstellt.

6. Lichtempfindlicher Film nach Anspruch 5, dadurch gekennzeichnet, daß in der Formel (I) des siliciumhaltigen Polymeren $R^2$, $R^3$, $R^4$, $R^5$, $R^6$ und $R^7$ den Methylrest darstellen.

7. Lichtempfindlicher Film nach einem der Ansprüche 1 bis 4, dadurch gekennzeichnet, daß das siliciumhaltige Polymere der Formel entspricht:

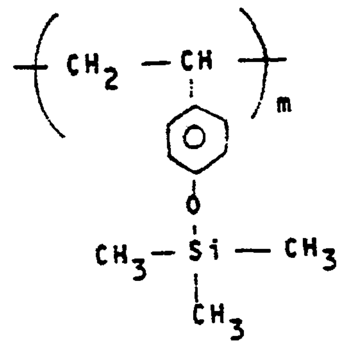

8. Lichtempfindlicher Film nach einem der Ansprüche 1 bis 7, dadurch gekennzeichnet, daß das genannte Salz ausgewählt wird aus den Sulfoniumsalzen, Diaryljodoniumsalzen, Triarylselenoniumsalzen und Triaryltelluroniumsalzen.

9. Lichtempfindlicher Film nach Anspruch 8, dadurch gekennzeichnet, daß das Sulfoniumsalz ein Salz der Formel ist

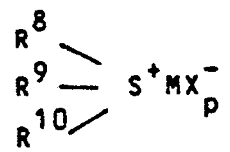

worin bedeuten:

$R^8$, $R^9$ und $R^{10}$, die gleich oder verschieden sein können, ggf. substituierte Arylreste,

M ein Element des Periodensystems der Elemente, das mit einem Halogen ein Anion bilden kann,

X ein Halogenatom und

p den Wert v + 1 hat, worin v den Valenzzustand von M darstellt.

10. Lichtempfindlicher Film nach Anspruch 8, dadurch gekennzeichnet, daß das Diaryljodoniumsalz die Formel hat

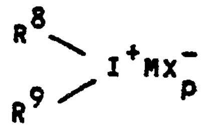

worin bedeuten:

$R^8$ und $R^9$, die gleich oder verschieden sein können, einen ggf. substituierten Arylrest,

M ein Element des Periodensystems der Elemente, das mit einem Halogen ein Anion bilden kann,

X ein Halogenatom und

p den Wert 1 + v hat, worin v die Valenz von M darstellt.

11. Lichtempfindlicher Film nach einem der Ansprüche 9 und 10, dadurch gekennzeichnet, daß $MX_p^-$ ausgewählt wird aus $BF_4^-AsF_6^-$, $PF_6^-$ und $Sb_6^-$.

12. Lichtempfindlicher Film nach einem der Ansprüche 1 bis 7, dadurch gekennzeichnet, daß es sich bei dem genannten Salz um das Triphenylsulfoniumhexafluoroarsenat oder Diphenyljodoniumhexafluoroarsenat handelt.

13. Lichtempfindlicher Film nach einem der Ansprüche 1 bis 12, dadurch gekennzeichnet, daß der Photosensibilisator ein aromatischer Kohlenwasserstoff ist.

14. Lichtempfindlicher Film nach Anspruch 12, dadurch gekennzeichnet, daß der Photosensibilisator Perylen ist.

15. Verfahren zum Maskieren bestimmter Zonen eines Substrats, dadurch gekennzeichnet, daß es die folgenden aufeinanderfolgenden Stufen umfaßt:

a) Abscheiden auf dem Substrat einer ersten Harzschicht mit einer solchen Dicke, daß sie eine Ausgleichsschicht des Substrats darstellt,

b) Abscheiden einer zweiten Schicht aus dem lichtempfindlichen Film nach einem der Ansprüche 1 bis 14 auf der ersten Harzschicht,

c) Bestrahlen der Zonen der zweiten Schicht, die den Zonen des Substrats entsprechen, die nicht maskiert werden dürfen, mit Strahlen mit einer Wellenlänge, die dem Lichtempfindlichkeitsbereich des lichtempfindlichen Films entspricht und

d) Eliminieren der zweiten Schicht aus dem lichtempfindlichen Film und der ersten Harzschicht an den Stellen, die den Zonen der zweiten Schicht entsprechen, die bestrahlt worden sind.

16. Verfahren nach Anspruch 15, dadurch gekennzeichnet, daß in der Stufe (d) zuerst die zweite Schicht aus dem lichtempfindlichen Film eliminiert wird durch Auflösen in einem Lösungsmittel und daß anschließend die erste Harzschicht durch in einem Gasplasma reaktive Ionengravur eliminiert wird.

17. Verfahren nach Anspruch 15, dadurch gekennzeichnet, daß in der Stufe (d) die zweite Schicht aus dem lichtempfindlichen Film und die erste Harzschicht durch in einem Gasplasma reaktive Ionengravur gleichzeitig eliminiert werden.

18. Verfahren nach einem der Ansprüche 15 bis 17, dadurch gekennzeichnet, daß die zweite Schicht aus dem lichtempfindlichen Film nach der Bestrahlung gebrannt wird.

19. Verfahren nach einem der Ansprüche 15 bis 18, dadurch gekennzeichnet, daß die erste Harzschicht aus Phenolformaldehydharz besteht.

20. Verfahren nach einem der Ansprüche 15 bis 19, dadurch gekennzeichnet, daß der lichtempfindliche Film auf 100 Gew.-Teile Poly-p-trimethylsilyloxystyrol 5 bis 15 Gew.-Teile Triphenylsulfoniumhexafluoroarsenat und 3 bis 10 Gew.-Teile Perylen enthält.

21. Verfahren nach Anspruch 20, dadurch gekennzeichnet, daß die Bestrahlung mit einer Wellenlänge von 386 bis 475 nm durchgeführt wird.

22. Siliciumhaltiges Polymeres, dadurch gekennzeichnet, daß es der Formel entspricht:

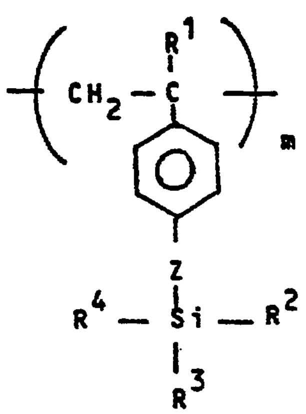

(I)

worin bedeuten:

$R^1$ H oder einen $C_1$–$C_4$-Alkylrest, $R^2$, $R^3$ und $R^4$, die gleich oder verschieden sein können, einen $C_1$–$C_4$-Alkylrest, Z –O–, $-(CH_2)_n-O-$, worin n eine ganze Zahl von 1 bis 4 darstellt, oder

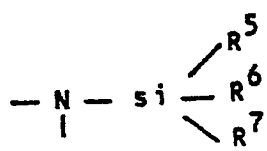

worin $R^5$, $R^6$ und $R^7$, die gleich oder verschieden sein können, einen $C_1$–$C_4$-Alkylrest darstellen, und m eine ganze Zahl von 25 bis 2000, mit der Maßgabe, daß $R^2$, $R^3$ und $R^4$ nicht $CH_3$ darstellen können, wenn $R^1$ H bedeutet, und daß Z –O–, $-O-CH_2-CH_2-$ oder $-N-Si(CH_3)_3$ darstellt.

## Claims

1. Photosensitive film, characterized in that it comprises:
a) at least one silicon-containing polymer in accordance with the formula:

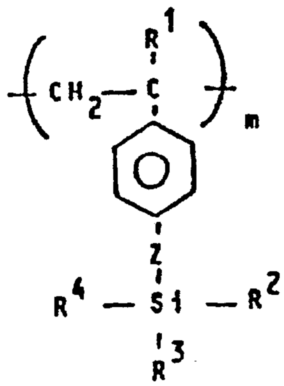

(I)

in which $R^1$ represents H or an alkyl radical in $C_1$ to $C_4$, $R^2$, $R^3$ and $R^4$, which can be the same or different, represent an alkyl radical in $C_1$ to $C_4$, Z represents $-O-$, $-(CH_2)_n-O-$ with n being an integer between 1 and 4, or

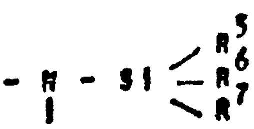

with $R^5$, $R^6$ and $R^7$, which can be the same or different, representing an alkyl radical in $C_1$ to $C_4$ and m being a number between 25 and 2000 and
b) at least one salt which can be converted into a Brönsted acid by irradiation.

2. Photosensitive film according to claim 1, characterized in that it also comprises:
c) at least one photosensitizer.

3. Photosensitive film according to either of the claims 1 and 2, characterized in that it comprises for 100 parts by weight of the silicon-containing polymer or polymers, 2 to 25 parts by weight of the said salt or salts and 0 to 10 parts by weight of the said photosensitizer or photosensitizers.

4. Photosensitive film according to either of the claims 2 and 3, characterized in that it comprises 3 to 10 parts by weight of the photosensitizer or photosensitizers per 100 parts by weight of said polymer or polymers.

5. Photosensitive film according to any one of the claims 1 to 4, characterized in that in formula (I) for the silicon-containing polymer, $R^1$ represents H or $CH_3$.

6. Photosensitive film according to claim 5, characterized in that in the formula (I) for the silicon-containing polymer $R^2$, $R^3$, $R^4$, $R^5$, $R^6$ and $R^7$ represent the methyl radical.

7. Photosensitive film according to any one of the claims 1 to 4, characterized in that the silicon-containing polymer is in accordance with the formula:

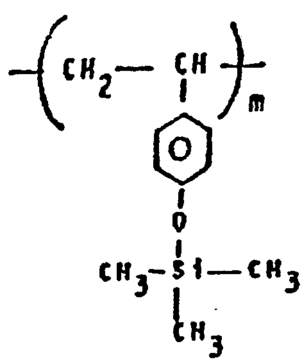

8. Photosensitive film according to any one of the claims 1 to 7, characterized in that said salt is chosen from among the sulphonium salts, the diaryliodonium salts, the triarylselenonium salts and the triaryltelluronium salts.

9. Photosensitive film according to claim 8, characterized in that the sulphonium salt is a salt of formula:

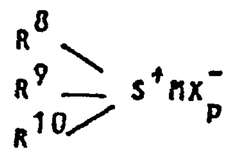

in which $R^8$, $R^9$ and $R^{10}$, which can be the same or different, are optionally substituted alkyl or aryl radicals, M is an element of the periodic classification of elements able to form an anion with a halogen, X is a halogen atom and p is equal to v + 1, with v representing the valency state of M.

10. Photosensitive film according to claim 8, characterized in that the diaryliodonium salt is in accordance with the formula:

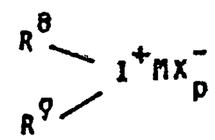

in which $R^8$ and $R^9$, which can be the same or different, represent an optionally substituted aryl radical, M represents an element of the periodic classification of elements able to form an anion with a halogen, X represents a halogen atom and p is equal to 1 + v, with v representing the valency of M.

11. Photosensitive film according to either of the claims 9 and 10 characterized in that $MX_p^-$ is chosen from among $BF_4^-$, $AsF_6^-$, $PF_6^-$ and $SbF_6^-$.

12. Photosensitive film according to any one of the claims 1 to 7, characterized in that said salt is triphenylsulphonium hexafluoroarsenate or diphenyliodonium hexafluorarsenate.

13. Photosensitive film according to one of the claims 1 to 12, characterized in that the photosensitizer is an aromatic hydrocarbon.

14. Photosensitive film according to claim 12, characterized in that the photosensitizer is perylene.

15. Process for masking certain zones of a substrate, characterized in that it comprises the following successive stages:

a) depositing on said substrate a first resin layer having a thickness such that it constitutes a leveling layer for the substrate,

b) depositing on said first resin layer, a second photosensitive film layer in accordance with any one of the claims 1 to 14,

c) irradiating the zones of the second layer corresponding to the substrate zones which are not to be masked, by means of radiation with a wavelength corresponding to the photosensitivity range of the photosensitive film, and

d) eliminating the second photosensitive film layer and the first resin layer at the points corresponding to the zones of the second layer which have been irradiated.

16. Process according to claim 15, characterized in that in stage d) firstly the second photosensitive film layer is eliminated by dissolving in a solvent and wherein the second resin layer is then eliminated by reactive ionic etching in a gaseous plasma.

17. Process according to claim 15, characterized in that in stage d), there is a simultaneous elimination of the second photosensitive film layer and the first resin layer by reactive ionic etching in a gaseous plasma.

18. Process according to any one of the claims 15 to 17, characterized in that, following irradiation, the second photosensitive film layer undergoes annealing.

19. Process according to any one of the claims 15 to 18, characterized in that the first resin layer is constituted by phenol formaldehyde resin.

20. Process according to any one of the claims 15 to 19, characterized in that the photosensitive film comprises for 100 parts by weight of poly-p-trimethylsilyloxystyrene, 5 to 15 parts by weight of triphenyl sulphoniumhexafluoroarsenate and 3 to 10 parts by weight of perylene.

21. Process according to claim 20, characterized in that irradiation takes place at a wavelength of 386 to 475 nm.

22. Silicon-containing polymer, characterized in that it is in accordance with formula:

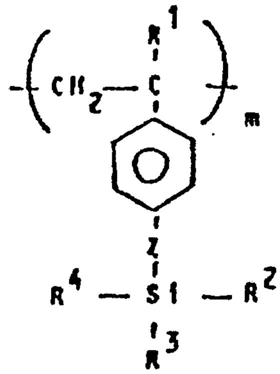

(I)

in which R1 represents H or an alkyl radical in $C_1$ to $C_4$, $R^2$, $R^3$ and $R^4$, which can be the same or different, represent an alkyl radical in $C_1$ to $C_4$, Z represents –O–, $-(CH_2)_n-O-$ with n being an integer between 1 and 4, or

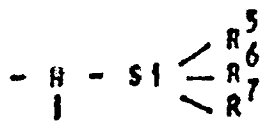

with $R^5$, $R^6$ and $R^7$, which can be the same or different, representing an alkyl radical in $C_1$ to $C_4$ and m is a number between 25 and 2000, provided that $R_2$, $R_3$ and $R_4$ do not represent $CH_3$, when $R^1$ represents H and Z represents –O–, $-O-CH_2-CH_2-$ or $-N-Si(CH_3)_3$.

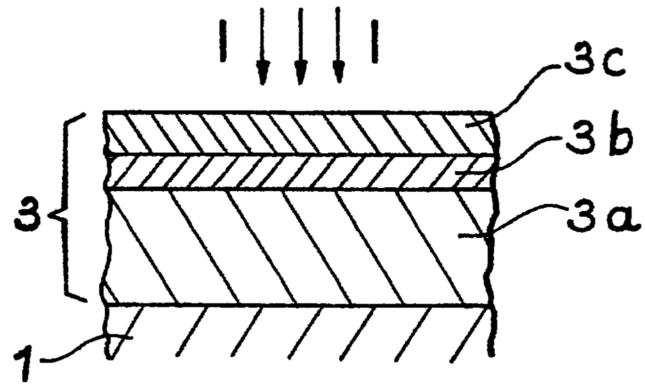


FIG. 1

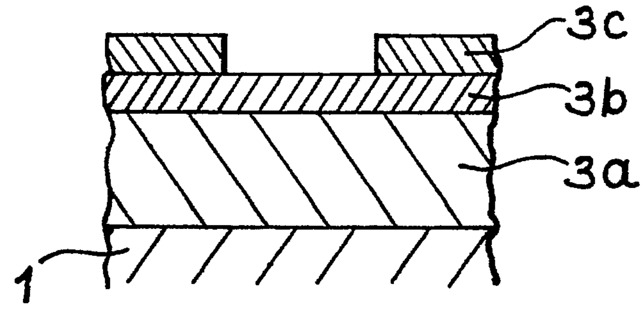


FIG. 2

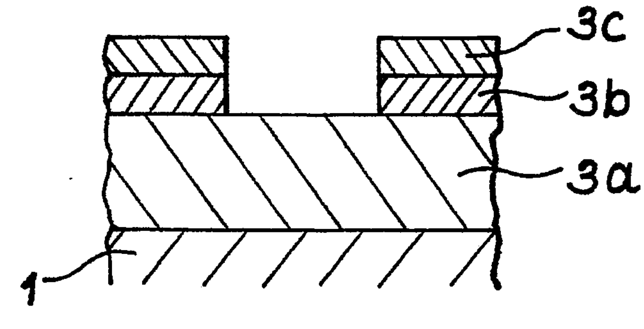


FIG. 3

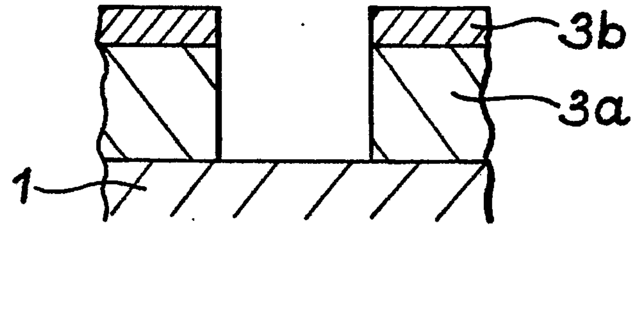


FIG. 4

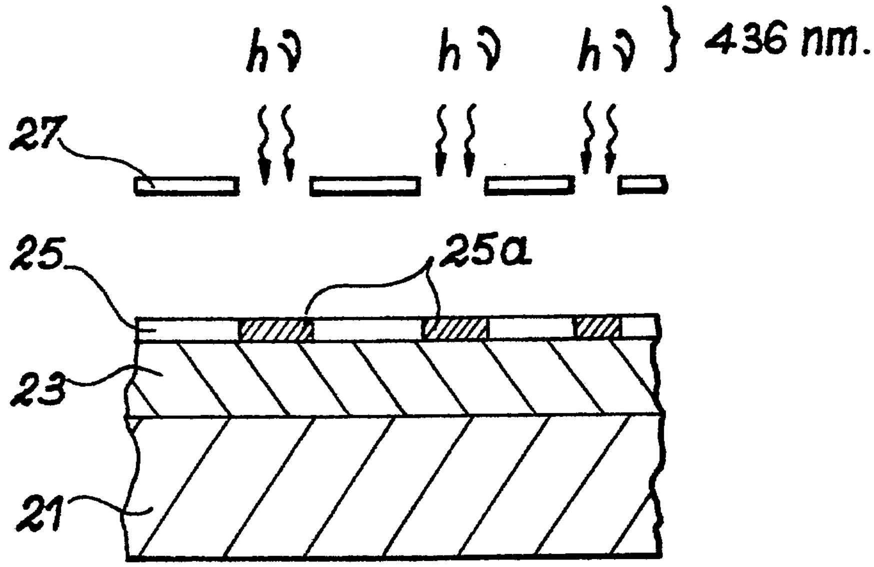


FIG. 5

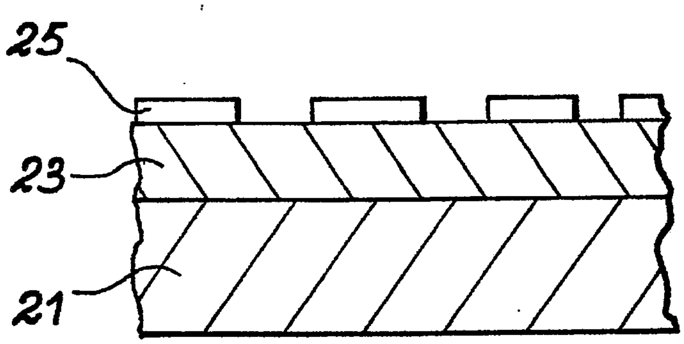


FIG. 6

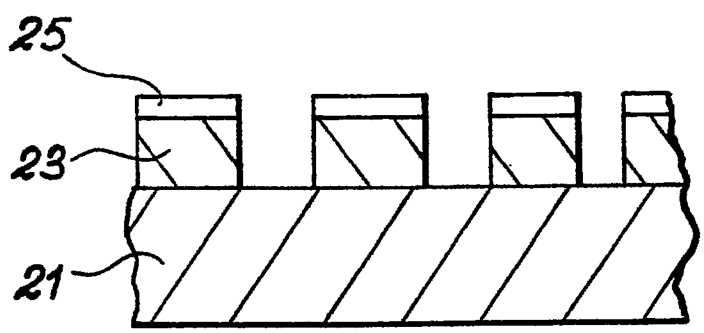


FIG. 7

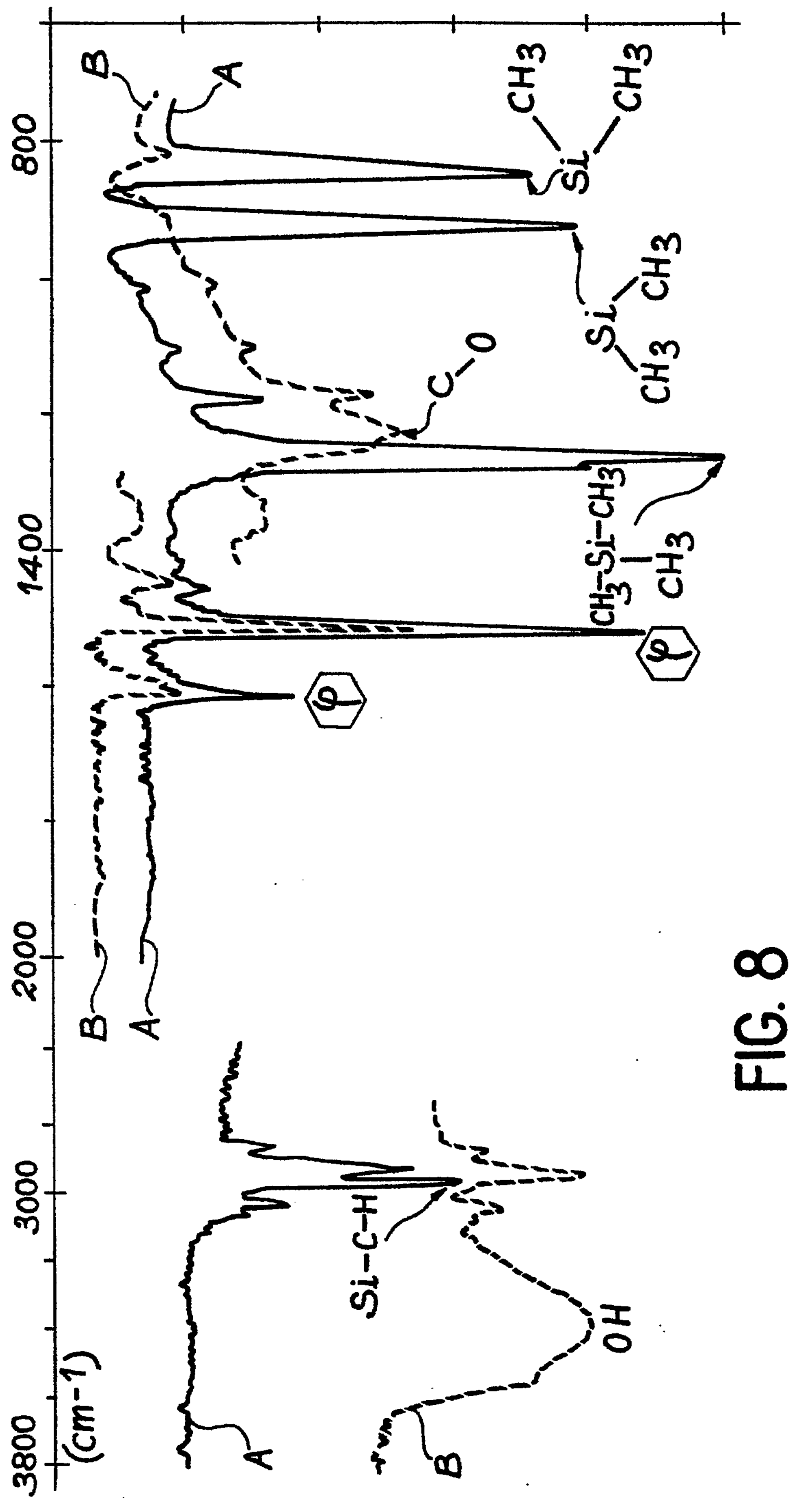


FIG. 8